# EUROPEAN PATENT SPECIFICATION

(11) **EP 3 029 781 B1**
(45) Date of publication and mention of the grant of the patent: **28.04.2021**
(21) Application number: 15182461.2
(22) Date of filing: 30.10.2008
(51) Int. Cl.: H01R 13/514, H01R 12/70, H01R 12/51, H01R 12/71, H01R 13/6471, H01R 13/6477, H05K 1/14, H05K 7/14, H05K 1/02, H05K 1/11, H05K 3/32

(54) **ELECTRICAL CONNECTOR SYSTEMS WITH ORTHOGONAL CONTACT TAILS**
ELEKTRISCHE VERBINDERSYSTEME MIT ORTHOGONALEN KONTAKTENDEN
SYSTÈMES DE CONNECTEUR ÉLECTRIQUE AVEC DES EXTRÉMITÉS DE CONTACT ORTHOGONALES

(30) Priority: 07.11.2007 US 986223 P; 05.08.2008 US 186064
(43) Date of publication of application: 08.06.2016
(62) Divisional of application: 08846823.6
(73) Proprietor: Amphenol FCI Asia Pte. Ltd., Singapore 368328 (SG)
(72) Inventor: Johnescu, Douglas M., Etters, PA 17319 (US); Minnich, Steven, Etters, PA 17319 (US); Smith, Stephen B., Mechanicsburg, PA 17055 (US)
(74) Representative: De Vries & Metman

(56) References cited:
- JP-A- 2002 203 623
- US-A1- 2002 181 217
- US-A1- 2006 073 709
- US-A1- 2007 099 455
- US-A1- 2007 149 057
- US-B1- 7 090 501

## Description

### FIELD OF THE INVENTION

Generally, the invention relates to electrical connectors. More particularly, the invention relates to connector applications wherein orthogonally-mated connectors share common vias through a midplane. The invention further relates to electrical connectors incorporating different sized connectors on each side of a midplane.

### BACKGROUND OF THE INVENTION

Electrical connectors may be used in orthogonal applications, as is for instance disclosed in US 7,090,501 and US 2007/099455 A1. In an orthogonal application, each of two connectors is mounted to a respective, opposite side of a PCB or midplane. The connectors are electrically coupled to one another through the midplane. A pattern of electrically conductive vias may be formed through the midplane. The terminal mounting ends of the contacts may be received into the vias. To reduce the complexity of the midplane, it is often desirable that the terminal mounting ends of the contacts from a first of the connectors be received into the same vias as the terminal mounting ends of the contacts from the other connector.

In traditional orthogonal electrical connector assemblies, two orthogonal connectors having the same number of contact leads are mounted to the midplane, one connector on each side of the midplane. However, this configuration may not allow for electrical connection of a connector contact to trace routing on the midplane PCB. Also, in traditional orthogonal electrical connector assemblies, only orthogonal leadframe assemblies are contained in each orthogonal connector. This configuration may limit the spacing between the PCB vias, which may limit the available channels for trace routing on the midplane PCB.

### SUMMARY OF THE INVENTION

According to the present invention, an assembly is provided as defined in claim 1. The electrical connectors can have "standard" (i.e., with electrical contacts having in-line tails), jogged (i.e., with electrical contacts having jogged tails but not connected orthogonally to another connector through a substrate), and/or "orthogonal" (i.e., with electrical contacts having jogged tails that are used in an orthogonal application) leadframe assemblies in the same connector. This provides the flexibility of using some of the available contacts in an orthogonal application and, at the same time, having remaining contacts available for routing on the midplane PCB. Though this could be done using only orthogonal leadframe assemblies, the combination of standard (contacts of a differential signal pair parallel to a contact centerline) leadframe assemblies with orthogonal leadframe assemblies creates additional spacing between the PCB vias, so that signal traces can be more easily routed on the midplane PCB.

The assembly may include a plurality of first differential signal pairs each arranged along a first common centerline, wherein all of the first differential signal pairs arranged along the first common centerline comprise first and second electrical contacts and the first and second electrical contacts are positioned on opposite sides of the first common centerline; and a plurality of second differential signal pairs are each arranged along a second common centerline, wherein all of the second differential signal pairs arranged along the second common centerline comprise third and fourth electrical contacts and the third and fourth electrical contacts are each positioned coincident with or parallel to the second common centerline. The second common centerline may be adjacent and parallel to the first common centerline. The electrical connector may further include a first ground contact positioned immediately adjacent to a respective one of each of the plurality of first differential signal pairs and\or a second ground contact positioned immediately adjacent to each of the plurality of second differential signal pairs. The electrical connector may be devoid of any metallic plates between the plurality of first differential signal pairs and the plurality of second differential signal pairs. A second electrical connector may further include a plurality of third differential signal pairs, wherein the plurality of first differential signal pairs each electrically connect orthogonally to a respective one of the plurality of third differential signal pair by common via. The second electrical connector may further include a plurality of third differential signal pairs, wherein less than all of the plurality of first differential signal pairs each electrically connect orthogonally to a respective one of the plurality of third differential signal pair by common vias.

The assembly may further include a plurality of third differential signal pairs arranged along a third common centerline, wherein all of the third differential signal pairs arranged along the third common centerline comprise fifth and sixth electrical contacts, the fifth and sixth electrical contacts are each positioned coincident with or parallel to the third common centerline, the third common centerline is adjacent and parallel to the second common centerline, and a centerline spacing between the first common centerline and the second common centerline is different than the centerline spacing between the second common centerline and the third common centerline. The first and second electrical contacts may be edge-coupled or broadside coupled and the plurality of first differential signal pairs may be carried by a leadframe housing.

Optionally, one of the plurality of differential signal pairs includes first and second contact tails configured to be orthogonally received in respective common vias of a printed circuit board and a second one of the plurality of differential signal pairs comprises third and fourth contact tails that are not orthogonally received in respective common vias of a printed circuit board. The first and second contact tails may be jogged to respective opposite sides of a first common centerline. The third and fourth contact tails may be coincident with a second common centerline that is adjacent and parallel to the first common centerline and the third and fourth contact tails may be jogged to respective opposite sides of a second common centerline that is adjacent and parallel to the first common centerline. The one of the plurality of differential signal pairs may be arranged along a first common centerline, the second one of the plurality of differential signal pairs may be arranged along a second common centerline that is adjacent and parallel to the first common centerline. The electrical connector may further include a third differential signal pair arranged along a third common centerline that is adjacent and parallel to the first common centerline, wherein a centerline spacing between the first common centerline and the second common centerline is different than the centerline spacing between the second common centerline and the third common centerline. A leadframe housing may carries the plurality of differential signal pairs.

The invention also provides an electrical connector comprising first type leadframe assemblies and second type leadframe assemblies. The first type leadframe assemblies have contact tails jogged on opposite sides of respective leadframe assembly centerlines; and the second type leadframe assemblies have contact tails disposed in pairs along respective leadframe assembly centerlines. Optionally, the contact tails of the first type leadframe assemblies serve as signal contact tails, wherein the first type leadframe assemblies further comprise a plurality of ground contact tails disposed along respective leadframe assembly centerlines.

### BRIEF DESCRIPTION OF THE DRAWINGS

FIGS. 1A, 1B, and 1C depict perspective views of an example 4x4 orthogonal connector and 6x6 mixed connector mounted orthogonally to one another through the use of shared vias in a midplane.
FIGs. 2A and 2B depict side views of the mounted connector pair.
FIG. 3 depicts a perspective view of the mounting side of the 6x6 mixed connector.
FIG. 4 depicts a perspective view of the mounting side of the 4x4 orthogonal connector.
FIG. 5 depicts a via footprint of a midplane for receiving the contact tails of the 6x6 mixed connector (the outline of which is shown in dashed line) mounted to the first side of the midplane.
FIG. 6 depicts an via footprint of a midplane for receiving the contact tails of the 4x4 orthogonal connector (the outline of which is shown in dashed line) mounted to the second side of the midplane.
FIG. 7 depicts a midplane showing a footprint arrangement for a 6x6 mixed connector, wherein the location of a 4x4 orthogonal connector on the opposite side is shown.
FIG. 8 depicts a transparent view through the midplane for the mounted connector pair, wherein each of the connectors is shown in dashed line.
FIG. 9 depicts a pin-out diagram of the midplane for the mounted connector pair, wherein a 4x4 orthogonal connector is electrically connected to a 6x6 mixed connector.
FIG. 10 depicts a pin-out diagram of the midplane for a second embodiment of the mounted connector pair, wherein a 4x4 orthogonal connector is electrically connected to a 6x6 mixed connector.
FIG. 11A depicts a midplane showing a footprint for a third embodiment of a 6x6 orthogonal connector, wherein the location of a 4x4 orthogonal connector on the opposite side is shown.
FIG. 11B depicts a pin-out diagram of the midplane for the third embodiment of FIG. 11A.
FIG. 12 depicts a pin-out diagram of the midplane for a fourth embodiment.
FIG. 13 depicts a midplane showing a footprint for a fifth embodiment of a 6x6 orthogonal connector, wherein the location of a 4x4 orthogonal connector on the opposite side is shown.
FIG. 14A depicts a perspective view of the mounting side of a sixth embodiment of an 8x6 mixed connector.
FIG. 14B depicts a perspective view of two 8x6 mixed connectors mounted orthogonally to one another through the use of shared vias in a transparent midplane.
FIG. 14C depicts a top view of the sixth embodiment mounted connector pair of FIG. 14B.
FIG. 14D depicts a transparent view through the midplane for the mounted connector pair of FIG. 14B, wherein each of the connectors is shown in solid line.
FIG. 14E depicts a pin-out diagram of the midplane for the sixth embodiment mounted connector pair of FIG. 14B.

### DETAILED DESCRIPTION OF ILLUSTRATIVE EMBODIMENTS

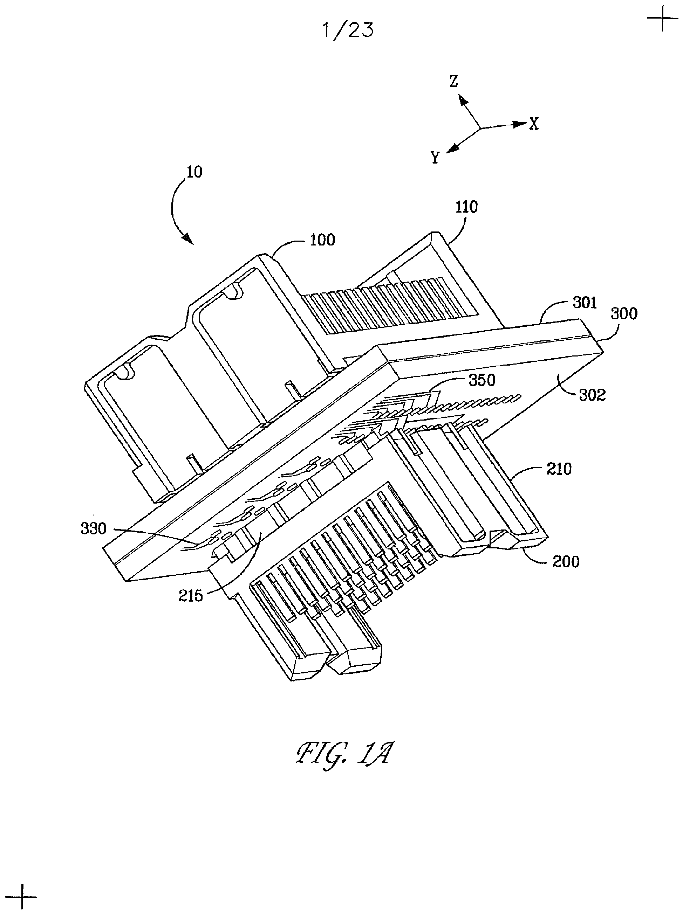

FIGs. 1A through 9 depict various aspects of an example embodiment electrical connector system according to the invention. FIG. 1A depicts a perspective view of an example 4x4 orthogonal connector and 6x6 mixed connector mounted orthogonally to one another through the use of shared vias in a midplane. The present invention can include a housing with stitched contacts or removable insert molded leadframe housings. The stitched contacts or removable insert molded leadframe housings can be mixed so that a single housing can be configured with various arrangements of orthogonal or non-orthogonal contacts, depending on the amount of orthogonal overlap or non-orthogonal PCB termination that is needed. Two connectors on opposite sides of a PCB, such as a midplane, can have identical housings and differing numbers of stitched contacts or leadframe assemblies. Alternatively, non-identical housings can also be used. Mixed connectors can be used to make trace routing easier.

Referring to Figure 1A, an example first embodiment electrical connector system 10 includes a mixed connector 100, an orthogonal connector 200, and a midplane 300. Mixed connector 100 includes a housing 110. Orthogonal connector 200 includes a housing 210 that contains four orthogonal (or jogged) leadframe assemblies 215 (or stitched contacts) arranged along a common centerline. Midplane 300 defines a first side 301 and a second side 302. Second side 302 includes (optionally) orthogonal via traces 330 and standard via traces 350. The traces 330 and 350 may be on the first side 301, the second side 320, or any layer of the PCB between the first side 301 and the second side 302. The mixed connector 100 and orthogonal connector 200 are typically headers with press-fit compliant terminals. The leadframe housings may comprise edge-coupled or broadside coupled differential signal pairs.

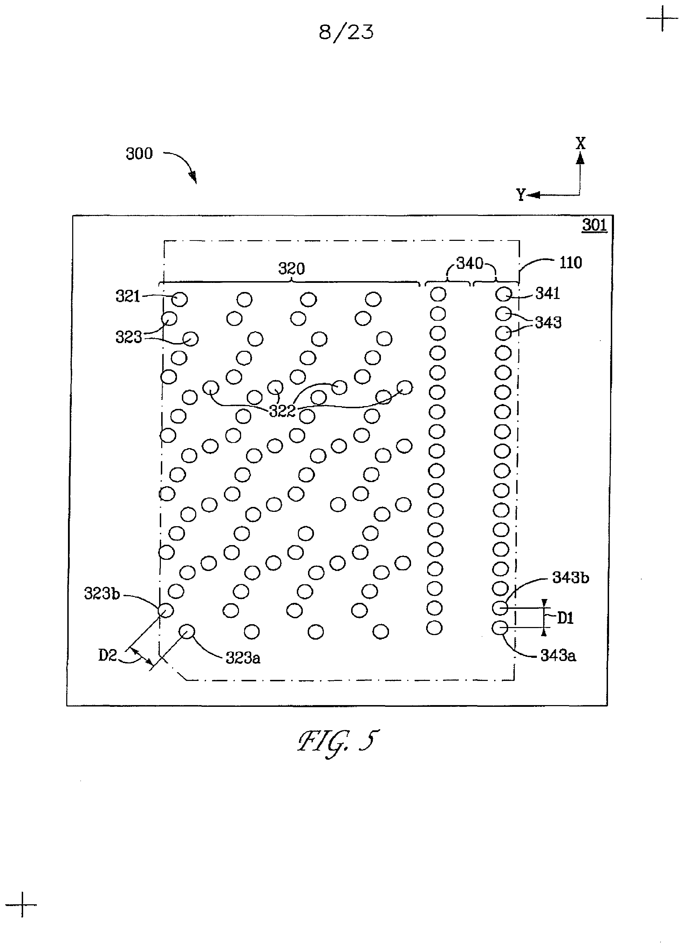

Mixed connector 100 and orthogonal connector 200 are mounted orthogonally (e.g., connector 100 is rotated ninety degrees (90°) with respect to connector 200) to one another through the use of the shared or other electrically connected orthogonal pattern of vias\plated through holes 320 (Fig. 5) in midplane 300. As shown in FIG. 1A, midplane 300 lies in a plane defined by the arrows designated X and Y shown in FIG. 1A. Mixed connector 100 is mounted on first side 301 of midplane 300, extending away from midplane 300 in the positive direction indicated by the arrow Z of FIG. 1A. Orthogonal connector 200 is mounted on second side 302 of midplane 300, extending away from midplane 300 in the negative Z direction, relative to mixed connector 100.

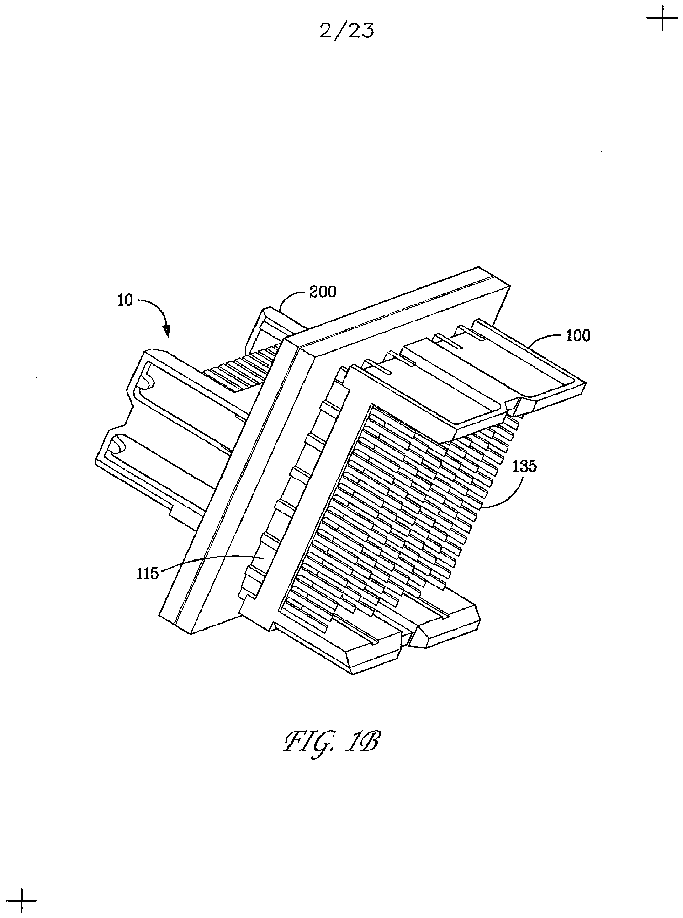

FIG. 1B depicts another perspective view of an example electrical connector system 10 that includes a 4x4 orthogonal connector 200 and 6x6 mixed connector 100 mounted orthogonally to one another through the use of shared vias in a midplane. FIG. 1B allows mixed connector 100 to be seen from the side containing orthogonal leadframe assemblies 115. Stitched contacts may also be used in place of leadframe assemblies. This view shows four orthogonal leadframe assemblies 115 and two standard leadframe assemblies 135 in mixed leadframe connector 100.

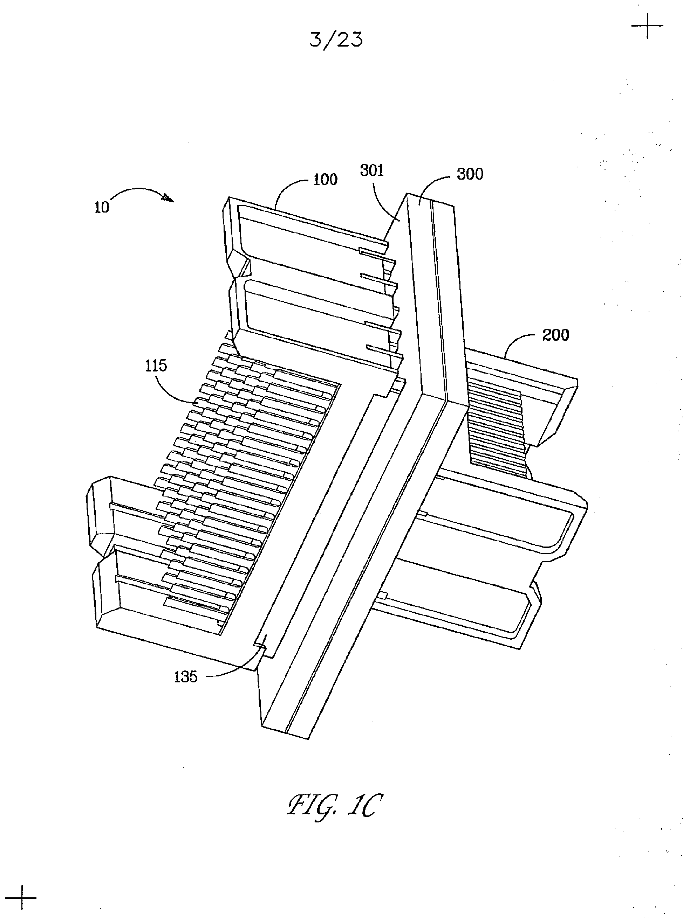

FIG. 1C depicts another perspective view of an example electrical connector system 10 that includes a 4x4 orthogonal connector 200 and a 6x6 mixed connector 100 mounted orthogonally to each other through the use of shared vias in a midplane 300. FIG. 1C allows mixed connector 100 to be seen from the side containing standard leadframe assemblies 135 (or stitched contacts), from the view of the first side 301 of midplane 300.

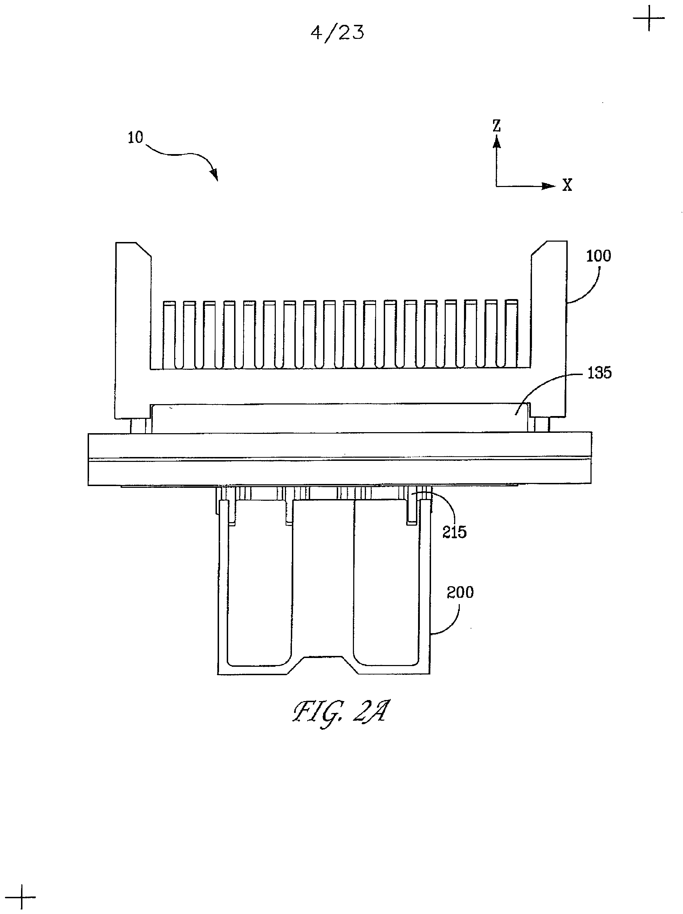

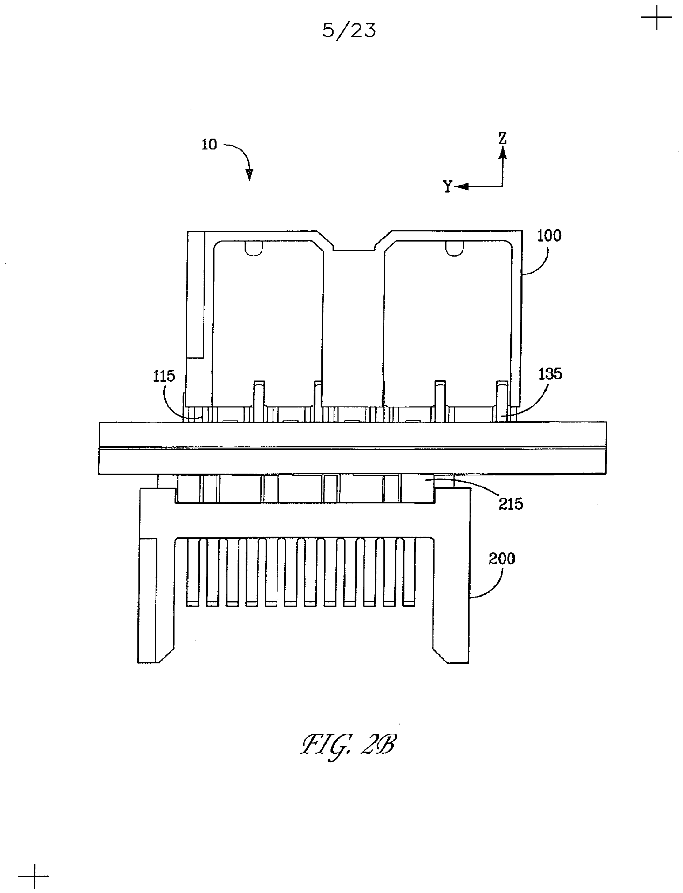

FIGs. 2A and 2B depict side views of the mounted connector pair of an example electrical connector system 10. FIG. 2A depicts the mounted connector pair viewed in the X-Z plane, as defined by the coordinate axis arrows shown in FIG. 1A. FIG. 2A allows mixed connector 100 to be seen from the side containing standard leadframe assemblies 135. FIG. 2B depicts the mounted connector pair viewed in the Y-Z plane, as defined by the coordinate axis arrows shown in FIG. 1A. FIG. 2A allows orthogonal connector 200 to be seen from the side, where one of the orthogonal leadframe assemblies 215 can be seen. FIG. 2B shows orthogonal leadframe assemblies 115 as well.

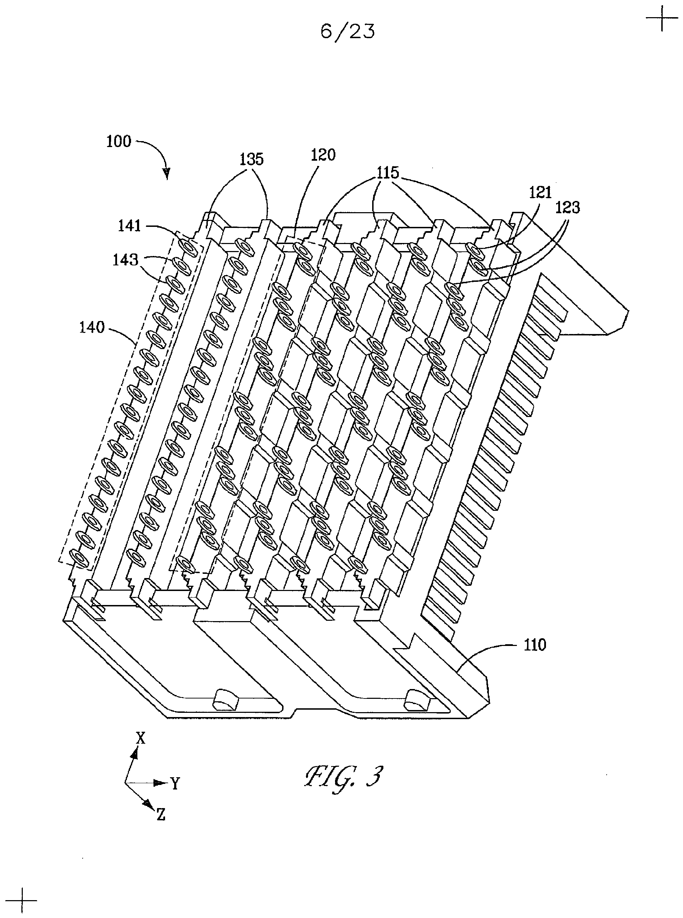

FIG. 3 depicts a perspective view of the mounting side of the 6x6 mixed connector 100 as the connector would be oriented and mounted to the first side of the midplane. In FIG. 3, the mounting side of the four orthogonal leadframe assemblies 115 and two standard leadframe assemblies 135 can be seen, as they are positioned within housing 110 of mixed connector 100. However, any combination of leadframe assemblies or stitched contacts is contemplated. Each orthogonal leadframe assembly 115 extends in the direction indicated by the arrow X of FIG. 1A and includes an orthogonal column of contact tails 120. Each orthogonal column of contact tails 120 extends in the direction indicated by the arrow X of FIG. 1A and includes ground contact tails 121 and signal contact tails 123. Each standard (non-jogged) leadframe assembly 135 extends in the direction indicated by the arrow X of FIG. 1A and includes a standard column of contact tails 140. Each standard column of contact tails 140 extends in the direction indicated by the arrow X of FIG. 1A and includes ground contact tails 141 and signal contact tails 143. Of course, the designation of the direction of columns is arbitrary.

Contact tails 121, 123, 141, and 143, as shown in FIG. 3 and other figures, may be freely assigned as ground or signal contact tails, depending on the desired function of connector system 10. In other embodiments, contact tails 121, 123, 141, and 143 may all be ground contact tails, they may all be signal contact tails, or they may be various combinations of ground and signal contact tails. The assignment of contact tails 121 and 141 as ground contact tails and contact tails 123 and 143 as differential signal contact tails merely illustrates the contact tail assignments in a preferred embodiment. Also, multiple contact tails 123 or 143 may be signal contact tails and they may form differential signal pairs. However, this is optional, as some of the contact tails 123 and 143 may form differential signal pairs, while others may not form differential signal pairs. In other embodiments, there may be no differential signal pairs, or all contact tails 123 and 143 may form differential signal pairs, depending on the desired function of connector system 10.

In the embodiment shown in FIG. 3, a mixed connector 100 may include at least one standard leadframe assembly 135, extending along a first direction (in the direction indicated by the arrow X of FIG. 1A), and having a third contact (either 141 or 143) and a fourth contact (either 141 or 143) adjacent the fourth contact along the first direction. In this embodiment, a mixed leadframe connector 100 may also include at least one orthogonal leadframe assembly 115 comprising a plurality of first differential signal pairs 121, the at least one orthogonal leadframe assembly 115 extending along the first direction (in the direction indicated by the arrow X of FIG. 1A). Each of the first differential signal pairs 121 includes a first electrical contact (either 121 or 123) and a second electrical contact (either 121 or 123) along a second direction that is different from the first direction.

Each orthogonal leadframe assembly 115 may either be "orthogonal" *(i.e.,* with electrical contacts having a jogged configuration or footprint that may be used in a common via or other orthogonal application) or jogged *(i.e.,* with electrical contacts having a jogged configuration or footprint but not connected orthogonally to another connector through a substrate by a via). Whether each orthogonal leadframe assembly 115 is assigned to be orthogonal or jogged will depend on the projected use and requirements of the electrical connector system 10.

Each orthogonal leadframe assembly 115, whether it is used in an orthogonal application or not, may contain one or more differential signal pairs including first and second contacts (either 121 or 123), the first and second contacts may be positioned on opposite sides of a respective first common centerline. Each orthogonal leadframe assembly 115 may also contain a respective first ground contact (either 121 or 123) adjacent to a respective second electrical contact. The first ground contact or contacts may be positioned along the first common centerline or offset from the first common centerline. The first and second electrical contacts and the ground contact may together form a jogged configuration or footprint of contacts, where the first electrical contact may be positioned along one respective side of the first common centerline and the second electrical contact may be positioned on an opposite respective side of the first common centerline.

Each standard leadframe assembly 135 may contain one or more second differential signal pairs each including third and fourth electrical contacts (either 141 or 143). The third and fourth electrical contacts may be positioned parallel to or coincident with a second common centerline that is generally adjacent to and parallel to the first common centerline. Each standard leadframe assembly 135 may also contain respective second ground contacts (either 141 or 143) adjacent respective ones of the fourth electrical contacts. The respective second ground contacts may be positioned along or parallel to the second common centerline. The third and fourth electrical contacts and the second ground contacts may together form a standard or straight configuration, where each successive contact is positioned along or coincident with the second common centerline.

In some embodiments, each orthogonal leadframe assembly 115 and/or each standard leadframe assembly 135 may comprise a single section or piece that may be inserted into the leadframe housing 110 of the mixed connector 100. In other embodiments, each orthogonal leadframe assembly 115 and/or each standard leadframe assembly 135 may comprise two dielectric sections that fit together. Each orthogonal leadframe assembly 115 and standard leadframe assembly 135 may comprise any number of sections that fit together, depending on the particular desired use and cost of electrical connector system 10.

Preferably, the mixed connector 100 does not contain metallic plates or shield between any of the orthogonal leadframe assemblies 115, between any of the standard leadframe assemblies 135, or between any the differential signal pairs. In other embodiments, the mixed connector 100 may contain one or more metallic or energy absorbing plates between the orthogonal leadframe assemblies 115 or the standard leadframe assemblies 135. The use or absence of metallic plates in the mixed connector 100 will depend on the particular desired use, dimensions, and performance requirements of electrical connector system 10.

In this embodiment, each orthogonal column of contact tails 120 contains six ground contact tails 121 and six differential signal pairs of signal contact tails 123. Each ground contact tail 121 is followed along the first common centerline by a pair of signal contact tails 123. Each orthogonal column of contact tails 120 generally proceeds in the X direction, as defined by the coordinate axis arrows shown in FIG. 1A, but each signal contact tail 123 has a positive or negative Y direction offset relative to each ground contact tail 121 or the first common centerline. In this embodiment, each standard column of contact tails 140 contains six ground contact tails 141 and six differential pairs of signal contact tails 143. Each ground contact tail 141 is followed along the second common centerline (in the X direction) by a pair of signal contact tails 143.

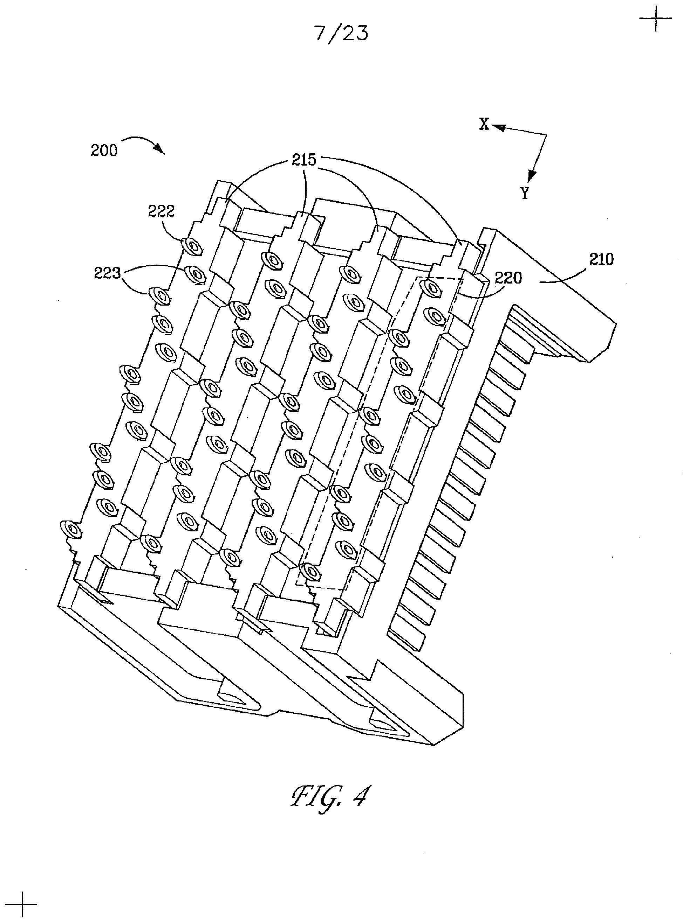

FIG. 4 depicts a perspective view of the mounting side of the 4x4 orthogonal connector 200 as the connector would be oriented and mounted to the second side of the midplane. In FIG. 4, the mounting side of the four orthogonal leadframe assemblies 215 can be seen, as they are positioned within housing 210 of orthogonal connector 200. Each orthogonal leadframe assembly 215 extends in the direction indicated by the arrow Y of FIG. 1A and includes contact tails 220 that extend along first common centerlines. Each orthogonal arrangement of contact tails 220 extends in the direction indicated by the arrow Y of FIG. 1A and includes ground contact tails 222 and signal contact tails 223. Of course, the designation of the direction of columns is arbitrary.

Each orthogonal leadframe assembly 215 may either be "orthogonal" *(i.e.,* with electrical contacts having a jogged configuration or footprint that are used in an orthogonal application) or jogged (*i.e*., with electrical contacts having a jogged configuration or footprint but not connected orthogonally to another connector through a substrate). Whether each orthogonal leadframe assembly 215 is assigned to be orthogonal or jogged will depend on the projected use.

Each orthogonal leadframe assembly 215, whether it is used in an orthogonal application or not, may contain one or more differential signal pairs including first and second contacts (either 222 or 223), the first and second contacts positioned on opposite sides of a first common centerline. Each orthogonal leadframe assembly 215 may also contain a ground contact (either 222 or 223) adjacent one or more of the respective first and second contacts that may be positioned along the first common centerline. The first and second contacts and the ground contact may together form a jogged configuration or footprint of contacts, where each successive contact along the first common centerline alternates among being positioned to one side of the first common centerline, to the other side of the first common centerline, and along the first common centerline.

In this embodiment, each orthogonal column of contact tails 220 contains four ground contact tails 221 and four pairs of signal contact tails 223. Each ground contact tail 221 is followed in the column by a pair of signal contact tails 223. Each orthogonal column of contact tails 220 generally proceeds in the Y direction, as defined by the coordinate axis arrows shown in FIG. 1A, but each signal contact tail 223 has a positive or negative X direction offset relative to each ground contact tail 221.

FIG. 5 depicts an via footprint of a midplane 300 for receiving the contact tails of the 6x6 mixed connector 110 (the outline of which is shown in dashed line) mounted to the first side 301 of the midplane. In FIG. 5, first side 301 of midplane 300 is shown, viewed in the X-Y plane, as defined by the coordinate axis arrows shown in FIG. 1A. First side 301 is the side that is adapted to mate with mixed connector 100. The dashed line represents the outside boundaries in the X-Y plane of the housing 110 of mixed connector 100. Midplane 300 further defines an orthogonal pattern of vias 320 that extend from first side 301 to second side, and two standard columns of vias 340 that extend from first side 301 to second side. Orthogonal pattern of vias 320 includes first side ground vias 321, second side ground vias 322, and signal vias 323. Standard columns of vias 340 include first side ground vias 341 and signal vias 343.

Vias 321, 322, 323, 341, and 343, as shown in FIG. 5 and other figures, may be freely assigned as ground or signal vias, depending on the desired function of connector system 10. Also, multiple vias 323 or 343 may be signal vias, which may be adapted to receive differential signal pair contact tails. However, this is optional, as some of the vias 323 and 343 may be adapted to receive differential signal pair contact tails of a connector, while others may not be adapted to receive differential signal pair contact tails.

In the embodiment shown in FIG. 5, a midplane 300 may include a first side 301 and a second side opposing the first side. Midplane 300 may also include a first via (either 341 or 343) extending from first side 301 to second side, and a second via (either 341 or 343) adjacent the first via along a first direction (in the direction indicated by the arrow X of FIG. 1A). In this embodiment, a midplane 300 may also include a third via (any of 321, 322, 323), and a fourth via (any of 321, 322, 323) adjacent the third via along a second direction different than the first direction. Vias 341, 343 can terminate blind inside the midplane 300 as well.

As shown in FIG. 5, the first via may be 343a, the second via may be 343b, the third via may be 323a, and the fourth via may be 323b. In some embodiments, each of the first, second, third, and fourth vias may define respective first, second, third, and fourth centers. A distance D1 from the first center of first via 343a to the second center of second via 343b is less than a distance from the first center of first via 343a to a center of any other via in midplane 300 (*e.g.,* first via 343a and second via 343b are successive vias, in the direction indicated by the arrow X of FIG. 1A, in a standard column of vias 340). A distance D2 from the third center of third via 323a to the fourth center of fourth via 323b is less than a distance from the third center of third via 323a to a center of any other via in midplane 300 (*e.g*., third via 343a and fourth via 343b are adjacent vias, located within an orthogonal pattern of vias 320).

In some embodiments, the first and second vias 343a, 343b may be adapted to receive respective third and fourth contacts (either 141 or 143; FIG. 3) that form a second differential signal pair of an electrical connector 100 when the mixed connector 100 is mounted to the first side 301 of the midplane 300. Third and fourth vias 343a, 343b may be adapted to receive respective first and second contacts (either 121 or 123) that form a first differential pair of the electrical connector 100. Also, mixed connector 100 defines orthogonal contact tails 120 and standard contact tails 140 that are adapted to mount, respectively, onto the orthogonal pattern of vias 320 and the standard columns of vias 340 defined by midplane 300, as viewed from first side 301.

In this embodiment, at the first side 301 of midplane 300, each first side ground via 321 and each signal via 323 within the orthogonal pattern of vias 320 is adapted to receive, respectively, a ground contact tail 121 and a signal contact tail 123, from the orthogonal columns of contact tails 120, from mixed connector 100 (shown in FIG. 3).

In this embodiment, there are enough vias 321 and 323 to allow for respective mating, at first side 301, with the contact tails 121 and 123 contained within the four orthogonal columns of contact tails 120, which allows the four orthogonal leadframe assemblies 115 of connector 100 to be mounted onto first side 301 of midplane 300. However, in other embodiments, some contact tails 121 and 123 may be devoid of reception into a corresponding via 321 or 323, and some vias 321 and 323 may be devoid of a contact tail 121 or 123 (FIG. 3).

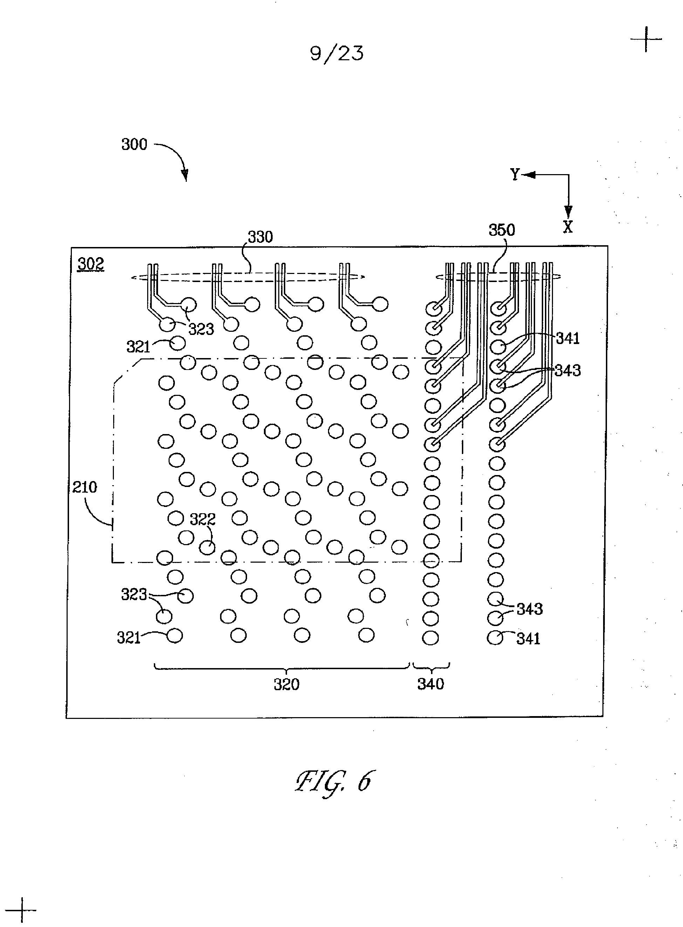

Each second side ground via 322 remains devoid of receiving a contact tail at first side 301, from mixed connector 100. These second side ground vias 322 are used to provide grounding for orthogonal leadframe connector 200 (shown in FIG. 4), which is mounted at second side 302 (FIG. 6).

In this embodiment, at the first side 301 of midplane 300, each first side ground via 341 and each signal via 343 within the standard columns of vias 340 is adapted to receive, respectively, a ground contact tail 141 and a signal contact tail 143, from the standard columns of contact tails 140, from mixed connector 100 (shown in FIG. 3).

In this embodiment, there are enough vias 341 and 343 to allow for respective mating, at side 301, with the contact tails 141 arid 143 (FIG. 3) contained within the two standard columns of contact tails 140, which allows the two standard leadframe assemblies 135 of connector 100 to be mounted onto first side 301 of midplane 300. However, in other embodiments, some vias 341 and 343 may be devoid of a contact tail 141 or 143.

FIG. 6 depicts an via footprint of a midplane 300 for receiving the contact tails of a 4x4 orthogonal connector (the outline of which is shown in dashed line) mounted to the second side of the midplane. In FIG. 6, second side 302 of midplane 300 is shown, viewed in the X-Y plane, as defined by the coordinate axis arrows shown in FIG. 1A. Second side 302 is the side that is adapted to mate with orthogonal connector 200 (shown in FIG. 4). The dashed line represents the outside boundaries in the X-Y plane of leadframe housing 210 of orthogonal leadframe connector. Second side 302 includes (optionally) orthogonal via traces 330 that originate from the orthogonal pattern of vias 320 and (optionally) standard via traces 350 that originate from the standard columns or rows of vias 340.

Orthogonal connector 200 (shown in FIG. 4) defines contact tails 220 arranged along a first common centerline that are adapted to mount onto a portion of the orthogonal pattern of vias 320 defined by midplane 300, as viewed from second side 302.

In this embodiment, at the second side 302 of midplane 300, each second side ground via 322 within the orthogonal pattern of vias 320 is adapted to receive a ground contact tail 222, from connector 200 (shown in FIG. 4). At the second side 302, some of the signal vias 323 within the orthogonal pattern of vias 320 receive a signal contact tail 223, from connector 200 (FIG. 4).

In this embodiment, there are enough vias 322 and 323 to allow for respective mating, at second side 302, with (FIG. 4) the contact tails 222 and 223 contained within the four orthogonal columns of contact tails 220, which allows the four orthogonal leadframe assemblies 215 of connector 200 to be mounted onto second side 302 of midplane 300. However, in other embodiments, some contact tails 222 and 223 may be devoid of reception into a corresponding via 322 or 323, and the number of vias 322 and 323 that are devoid of a contact tail 222 or 223 may vary, depending on the application.

Each first side ground via 321 remains devoid of receiving a contact tail at second side 302, from connector 200 (FIG. 4). These first side ground vias 321 are used to provide grounding for mixed leadframe connector 100 (shown in FIG. 3), which is mounted at first side 301. Also, although each of the signal contact tails 223 is received into a signal via 323, some of the signal vias 323 (specifically, in this embodiment, those that fall outside of the dashed line that represents the outside boundaries in the X-Y plane of leadframe housing 210) may (optionally) remain devoid of receiving any contact tails at second side 302, from connector 200. These signal vias 323 that are devoid of a contact tail at second side 302 are only used to mate with signal contact tails 123 from mixed connector 100 at first side 301.

As shown in FIG. 6, the portion of the signal vias 323 that are devoid of receiving any contact tails at second side 302, from connector 200 (those that fall outside of the dashed line that represents the outside boundaries of leadframe housing 210 of orthogonal connector 200), allow the corresponding signal contact tails 123 from connector 100 to be (optionally) electrically connected to respective orthogonal via traces 330 that originate from these respective signal vias 323.

The extra space made available on the second side 302 of midplane 300 (and/or the first side 301 in other embodiments), due to a portion of the signal vias 323 within the orthogonal pattern of vias 320 being unoccupied on second side 302, allows for increased routing space on second side 302 or any layer of the PCB for orthogonal via traces 330 *(i.e.,* traces on second side 302 that are electrically connected to connector 100 through use of signal vias 323), around the orthogonal pattern of vias 320.

Each first side ground via 341 and signal via 343 within the two standard columns\centerlines of vias 340 remains devoid of receiving a contact tail at second side 302, from connector 200. These standard columns of vias 340 are only used to mate with the standard columns of contact tails 140 from mixed leadframe connector 100 (shown in FIG. 3), which is mounted at first side 301.

As shown in FIG. 6, having the signal vias 323 within the standard columns\centerlines of vias 340 remain devoid of receiving any contact tails at second side 302, from connector 200, allows the corresponding signal contact tails 143 from the standard columns\centerlines of contact tails 140 from connector 100 to be (optionally) electrically connected to respective standard via traces 350 that originate from these respective signal vias 343.

The extra space made available on the second side 302 of midplane 300 (and/or the first side 301 in other embodiments), due to the signal vias 343 within the standard columns of vias 340 being unoccupied on second side 302, allows for increased routing space on second side 302 for standard via traces 350 *(i.e.,* traces on second side 302 that are electrically connected to connector 100 through use of signal vias 343), around the standard columns of vias 340.

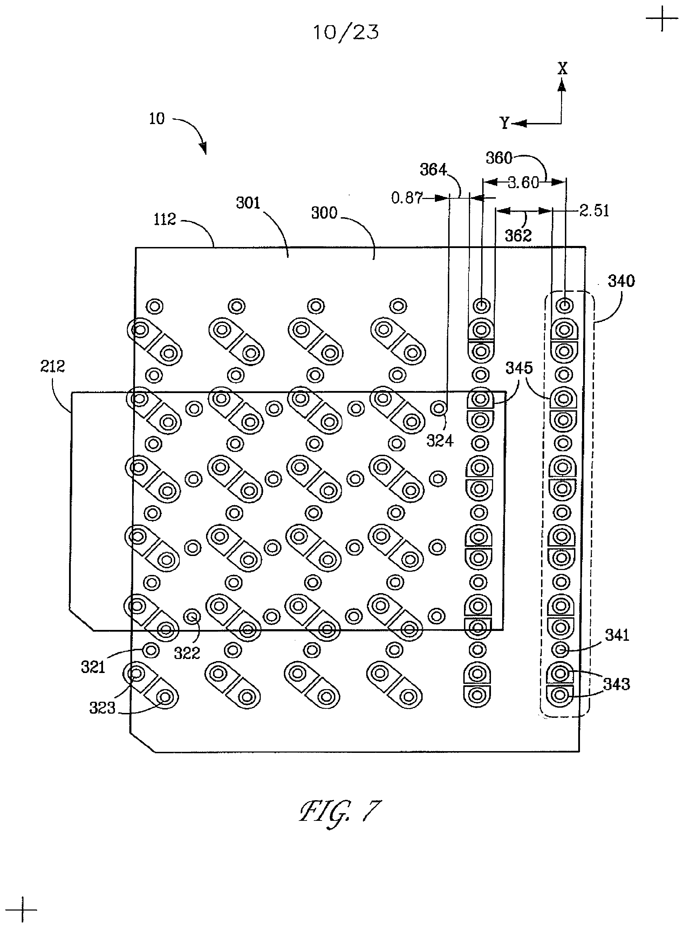

FIG. 7 depicts a midplane 300 showing a footprint arrangement for a 6x6 mixed connector, wherein the location of a 4x4 orthogonal connector on the opposite side is shown. FIG. 7 shows the midplane footprint from the view of first side 301 of midplane 300, and the outer boundaries of the leadframe housings are shown in solid lines 112 and 212, respectively. As shown in FIG. 7, the presence of standard columns of vias 340 that are devoid of receiving any contact tails at second side 302 from connector 200 allows for increased trace routing space on second side or on any layer of the PCB.

In this embodiment, the standard columns (or rows) of vias 340 are spaced 3.60 millimeters apart (standard via column center spacing 360). This standard via column center spacing 360, measured along the direction indicated by the arrow Y of FIG. 1A, represents the distance from the center of one first side ground via 341 or signal via 343 in one standard column of vias 340 to the center of a corresponding first side ground via 341 or signal via 343 in another standard column of vias 340. Of course, standard via column center spacing 360 may be any value, depending on the desired arrangement of signal contact tails within the standard columns\centerlines of contact tails.

Also shown in FIG. 7 is an electrical connector system 10 with standard via trace routing channel 362 and orthogonal via trace routing channel 364. In this embodiment, standard via trace routing channel 362 is 2.51 millimeters, and orthogonal via trace routing channel 364 is 0.87 millimeters. Standard via trace routing channel 362 is the inner portion of standard via column center spacing 360 that lies between the outer boundaries of the signal via anti-pads 345 in the two standard columns of vias 340. Of course, standard via trace routing channel 362 may be any value, depending on the desired arrangement of signal contact tails and on the desired anti-pad 345 width. Ground vias 321, 322, 324 and signal vias 323 are also shown.

Also, although not shown in FIG. 7, there may be additional trace routing space for more standard via traces on second side of midplane 300 to the outside of the outer boundary of leadframe housing of connector. This additional trace routing space available in this embodiment can best be seen in FIG. 6, where three pairs of standard via traces are shown within standard via trace routing channel, and three additional standard via traces are shown towards the outer edge of midplane 300, extending from the outer standard column of vias.

In this embodiment, orthogonal via trace routing channel 364 is the distance from the outer boundaries of the signal via anti-pads 345 in the innermost standard columns of vias 340 to the outer boundaries of the closest ground via 324 anti-pads of the orthogonal pattern of vias 320. Of course, orthogonal via trace routing channel 364 may be any value, depending on the desired arrangement of signal contact tails within the orthogonal columns of contact tails and signal contact tails within the standard columns of contact tails. Although orthogonal via traces 330 are not shown routed through orthogonal via trace routing channel 364 in FIG. 7, there may be enough room within orthogonal via trace routing channel 364 for orthogonal via traces 330 that may be desired in other embodiments.

Also, although not shown in FIG. 7, there may be additional trace routing space for more orthogonal via traces on the second side or layers of midplane 300 to the outside of the outer boundary of leadframe housing of connector. This additional trace routing space available in this embodiment can best be seen in FIG. 6, where four pairs of orthogonal via traces 330 are shown towards the outer edge of midplane 300, extending from the outermost signal vias 323 in the orthogonal pattern of vias 320. Further, although not shown in FIGs. 6 or 7, there may be additional trace routing space for four more pairs of orthogonal via traces 330, extending from the outermost signal vias 323 on the opposite side of the orthogonal pattern of vias 320 (the signal vias 323 closest to the bottom of FIG. 6), also outside the outer boundary of leadframe housing 210 of connector 200.

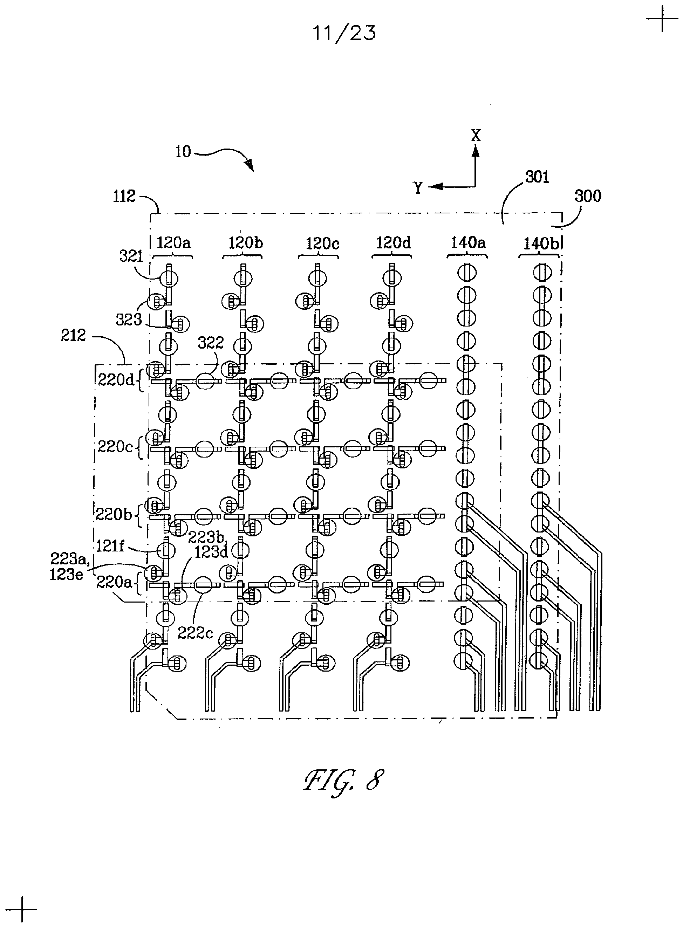

FIG. 8 depicts a transparent view of a connector system 10 through the first side 301 of a midplane 300 for the mounted connector pair, wherein each of the connector housings 112, 212 is shown in dashed line. FIG. 8, which is shown from the view of first side 301 of midplane 300, shows the details of the electrical mating between the orthogonal columns of contact tails 120 of mixed connector 100 (shown in FIG. 3) and the orthogonal columns of contact tails 220 of orthogonal connector 200 (shown in FIG. 4), through the shared use of the orthogonal pattern of vias in midplane 300 (shown in FIG. 5).

In this embodiment, the four orthogonal columns of contact tails 120a, 120b, 120c, and 120d of housing 112 extend in the direction indicated by the arrow X of FIG. 1A. The four orthogonal columns of contact tails 220a, 220b, 220c, and 220d of orthogonal connector 200 extend in the direction indicated by the arrow Y of FIG. 1A. Also shown in FIG. 8 are two standard columns of contact tails 140a and 140b of mixed connector 100, which, in this embodiment, are not electrically connected to corresponding contact tails of orthogonal connector 200 (FIG. 4).

Mixed connector 100 (FIG. 3) and orthogonal connector 200 (FIG. 4) "share" a portion of the signal vias 323 within the orthogonal pattern of vias defined by midplane 300. This allows electrical connection between the signal contact tail 123e from connector 100 (FIG. 3) and the signal contact tail 223e from connector 200 (FIG. 4). Conversely, in this embodiment, the ground vias 321 and 322 are not shared by both connector 100 and connector 200. The first side ground vias 321 only receive ground contact tails 121 from connector 100, at the first side 301, while the second side ground vias 322 only receive ground contact tails 222 from connector 200, at the second side.

This embodiment provides an array of sixteen (16) orthogonal differential signal pairs. For example, orthogonal column of contact tails 120a from connector housing 112 contains signal contact tails 123d and 123e, which mates with signal contact tails 223a and 223b, respectively, contained in orthogonal column of contact tails 220a from connector housing 212, through shared signal vias 323 in midplane 300. Ground contacts 121f and 222c are also shown.

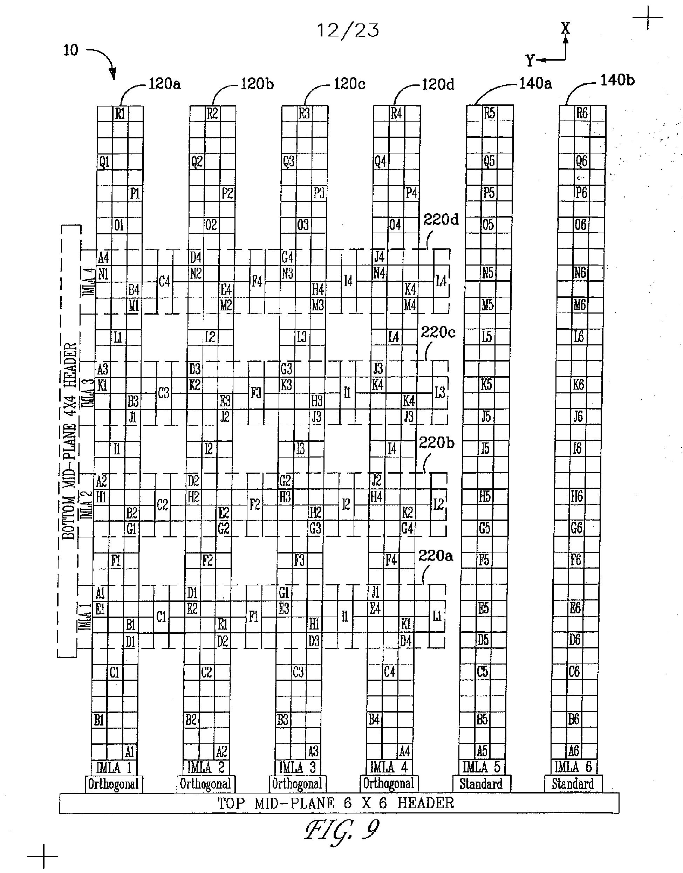

FIG. 9 depicts a pin-out diagram of an electrical connector system 10, wherein a portion of bottom mid-plane 4x4 header with jogged contact row\columns 220a-220d is electrically an orthogonally connected through a midplane to a portion of a top mid-plane 6x6 header with jogged contact row/columns 120a-120d and standard contact rows\columns 140a, 140b. FIG. 9, which is shown from a transparent view of a midplane, shows the details of electrical mating between orthogonal contact tails D1, E1; G1, HI, etc. of the top mid-plane 6x6 header and the orthogonal contact tails A1, B1; A2, B2, etc. of the bottom mid-plane 4x4 header positioned on the opposite side of the PCB. FIG. 9 shows sixteen (16) mated pairs of orthogonal differential signal contacts, such as through common vias. Ground tails C1, C2, etc. are the same for both connectors and are electrically connected, such as by common vias. Also shown in FIG. 9 are two standard columns or rows 140a, 140b of contact tails A5, B5, A6, B6, etc. on the top mid-plane 6x6 header, which, in this embodiment, are not electrically connected to corresponding contacts of the 4x4 header but could be by traces in the PCB.

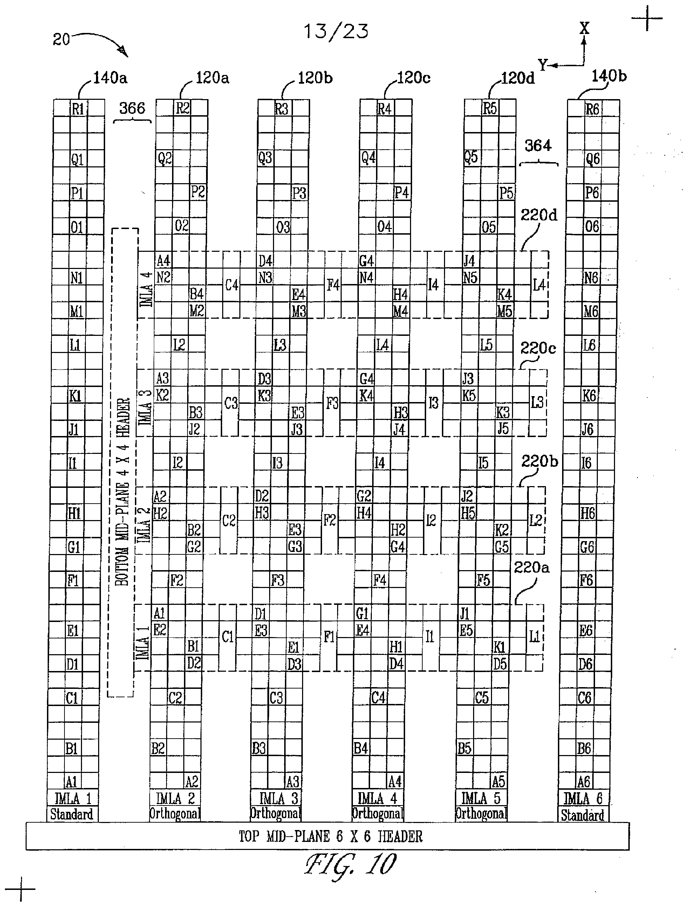

FIG. 10 depicts a pin-out diagram of an electrical connector system 20, wherein a bottom mid-plane 4x4 header with jogged contact row\columns 220a-220d is partially electrically and orthogonally connected through a midplane to a top mid-plane 6x6 header with jogged contact rows/columns 120a-120d and standard contact rows/columns 140a, 140b. FIG. 10, which is shown from a transparent view of a midplane, shows the details of electrical mating between orthogonal contact tails D2, E2; G2, H2, etc. of the top mid-plane 6x6 header and the orthogonal contact tails A1, B1; A2, B2, etc. of the bottom mid-plane 4x4 header positioned on the opposite side of the PCB. FIG. 10 shows sixteen (16) mated pairs of orthogonal differential signal contacts, such as through common vias. Ground tails C1, C2, etc. are the same for both connectors and are electrically connected, such as by common vias. Also shown in FIG. 10 are two standard columns or rows 140a, 140b of contact tails A1, B1, A6, B6, etc. on the top mid-plane 6x6 header, which, in this embodiment, are not electrically connected to corresponding contacts of the 4x4 header but could be by traces in the PCB.

This second embodiment, electrical connector system 20, is one of many alternatives to the first embodiment, wherein the order of orthogonal rows or columns of orthogonally connected contact tails is different than the first embodiment. Although not shown in FIG. 10, this second embodiment contains an orthogonal via trace routing channel 364 (FIG. 7), which may be 0.87 millimeters, and which may accommodate orthogonal via traces or standard via traces on a second side of the midplane. This second embodiment may also contain an additional trace routing channel which may be greater than 0.87 millimeters and which may accommodate either orthogonal via traces or standard via traces on a second side or on any other layer of the PCB.

The present invention is not limited to the mating arrangements shown in the first and second embodiments (FIGs. 1A through 10). One way to create additional embodiments is to position an orthogonal connector 200 (FIG. 2B) anywhere on the X-Y plane relative to mixed connector 100 (FIG. 2B), wherein the connectors 100, 200 overlap through the PCB and at least one differential signal pair is orthogonal.

Another way to create additional embodiments is to include different numbers of orthogonal columns of contact tails 120 and standard columns of contact tails 140 in connector 100 (FIG. 2B), and to include different numbers of orthogonal columns of contact tails 220 in connector 200 (FIG. 2B). Further, the order of the orthogonal columns of contact tails 120 and standard columns of contact tails 140 in connector 100 can be changed in various permutations, in addition to those of the first and second embodiments. Also, by varying the number of orthogonal columns of contact tails 120 and 220 and standard columns of contact tails 140, as well as the number of signal contact tails present in connectors 100 and 200, many different embodiments can be created.

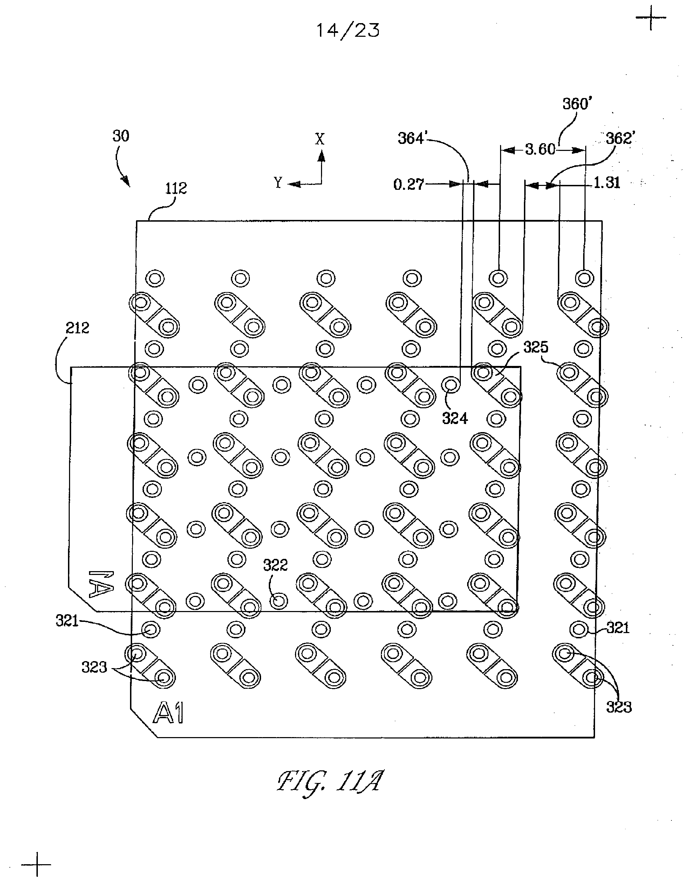

FIG. 11A depicts a midplane showing a footprint for a third embodiment of a 6x6 orthogonal connector 112, wherein the location of a 4x4 orthogonal connector 212 on the opposite side of the midplane is shown. The benefit of increased routing space for traces on the second side 302 or layers of midplane, shown in FIGs. 1A through 10, may also be realized in electrical connector system 30.

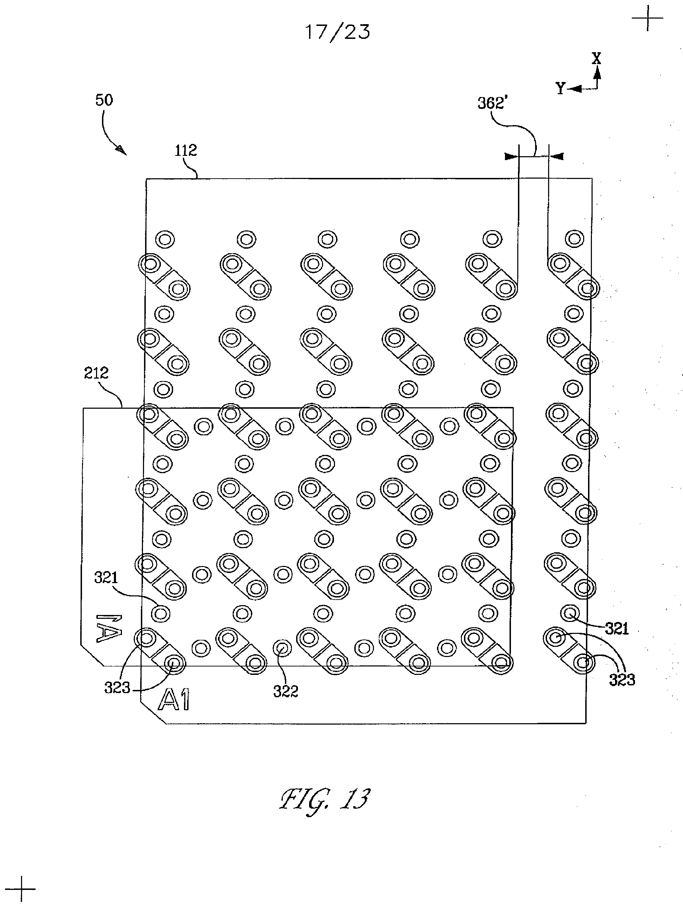

Also shown in FIG. 11A are alternate via trace routing channel 362' and orthogonal via trace routing channel 364'. In this embodiment, the alternate via column or row center spacing 360' shown in FIG. 11A may be the same as standard via column or row center spacing 360 (FIG. 7), which is 3.6 millimeters. A more narrow alternate via trace routing channel 362' is shown in FIG. 11A (1.31 millimeters) as compared to the wider standard via trace routing channel 362 shown in FIG. 7 (2.51 millimeters). Also, the orthogonal via trace routing channel 364' shown in FIG. 11A (0.27 millimeters) may be narrower than the wider orthogonal via trace routing channel 364 shown in FIG. 7. Alternate via trace routing channel 362' may be devoid of any second side ground vias 321, 322, 324. Differential signal vias and antipads 323, 325 are also shown. FIG. 13 is essentially the same as FIG. 11A, except connector 112 is moved in the X-direction in FIG. 13 as compared to FIG. 11A.

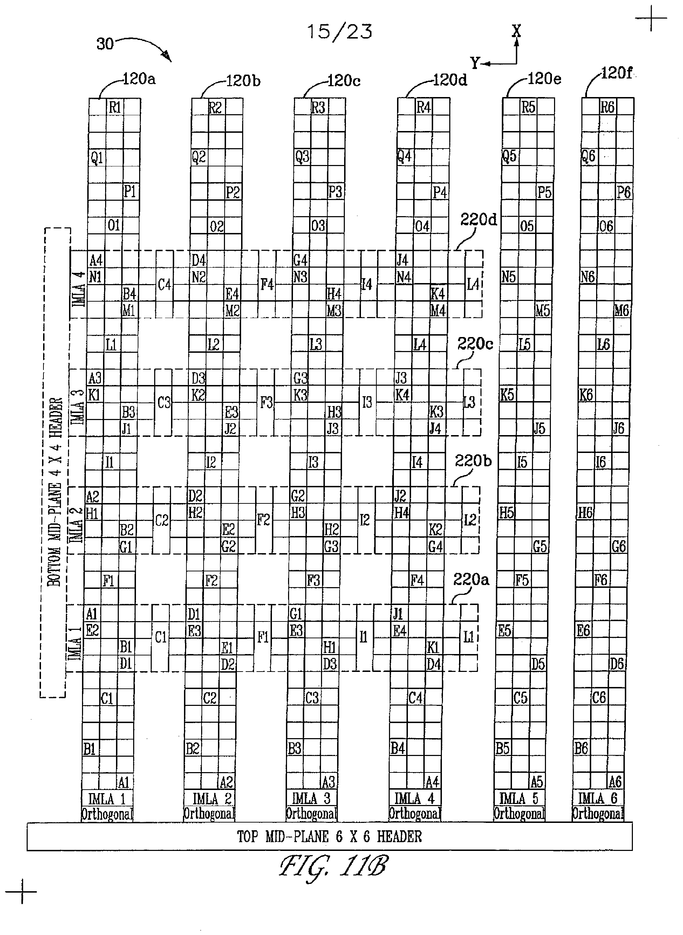

FIG. 11B depicts a pin-out diagram of an electrical connector system 30, wherein a bottom mid-plane 4x4 header with contact row/columns 220a-220d is orthogonally and electrically connected through a midplane to a portion of a top mid-plane 6x6 header with contact row/columns 120a-120f. FIG. 11B, which is shown from a transparent view of a midplane, shows the details of electrical mating between orthogonal contact tails D1, E1; G1, HI, etc. of the top mid-plane 6x6 header and the orthogonal contact tails A1, B1; A2, B2, etc. of the bottom mid-plane 4x4 header positioned on the opposite side of the PCB. FIG. 11B shows sixteen (16) mated pairs of orthogonal differential signal contacts, such as through common vias. Ground tails C1, C2, etc. are the same for both connectors and are electrically connected, such as by common vias. Also shown in FIG. 11B are additional columns or rows 120e, 120f of jogged electrical contacts A6, B6; D6, E6, etc. that could be used for orthogonal connectors but are terminated to the PCB only.

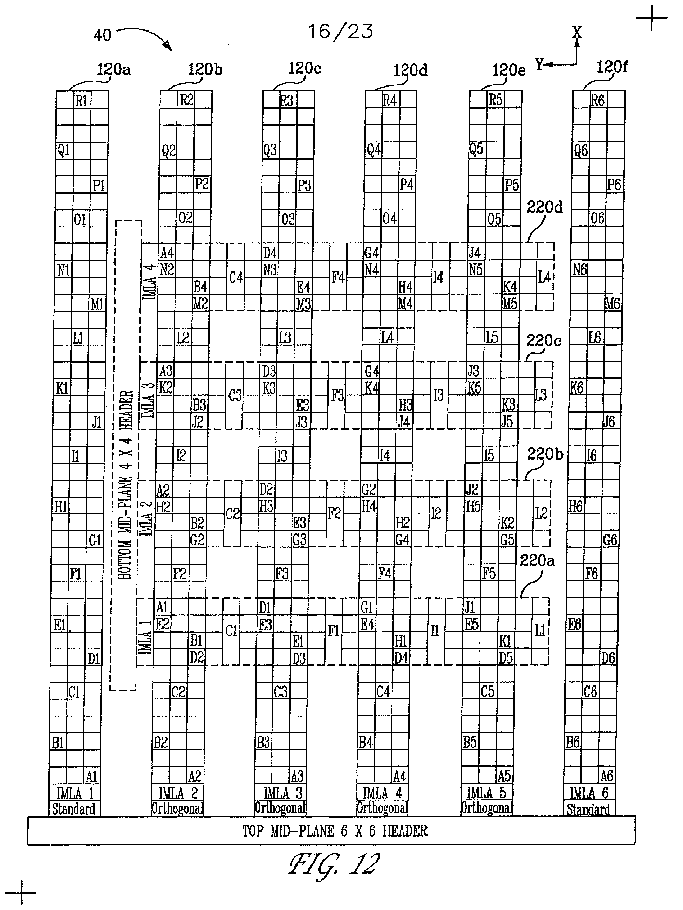

FIG. 12 depicts a pin-out diagram of the midplane for a fourth embodiment electrical connector system 40. FIG. 12 is similar to FIG. 11B, except columns/rows 120a and 120f terminate to the PCB instead of columns/rows 120e and 120f.

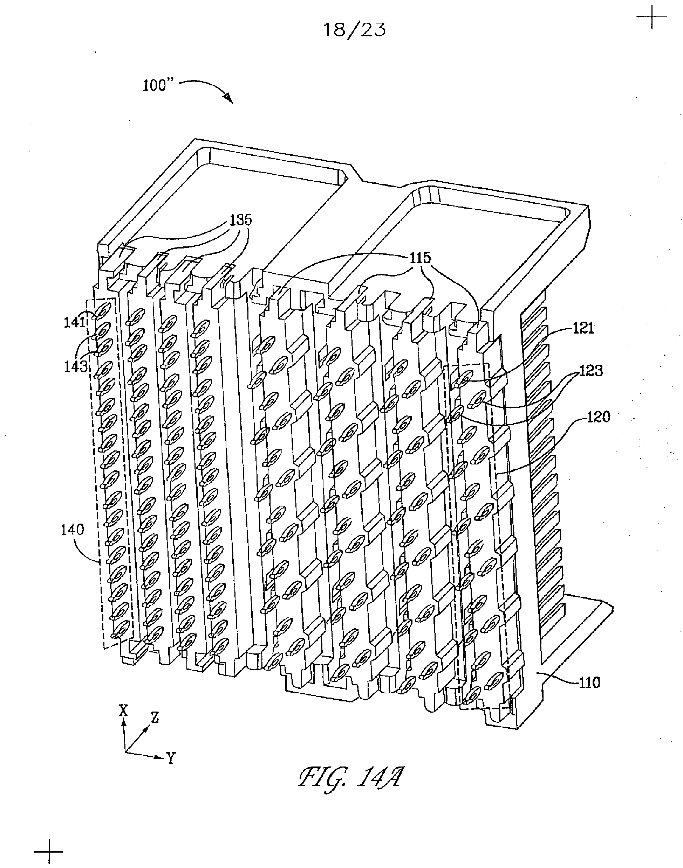

FIG. 14A depicts a perspective view of a mounting side of an 8x6 mixed connector 100". In FIG. 14A, the mounting side of the four (4) orthogonal leadframe assemblies 115 and four (4) standard leadframe assemblies 135 can be seen, as they are positioned within leadframe housing 110 of 8x6 mixed connector 100". Each orthogonal leadframe assembly 115 includes an orthogonal column of contact tails 120. Each orthogonal column of contact tails 120 extends in the direction indicated by the arrow X and includes ground contact tails 121 and signal contact tails 123. Each standard leadframe assembly 135 includes a standard column or row of contact tails 140. Each standard column of contact tails 140 extends in the direction indicated by the arrow X and includes ground contact tails 141 and signal contact tails 143. Of course, the designation of the direction of columns is arbitrary. The standard leadframe assemblies 135 may be on a different (greater than or less than) centerline spacing than the orthogonal leadframe assemblies 115. Spacing between leadframes can vary in any of the embodiments of the present invention.

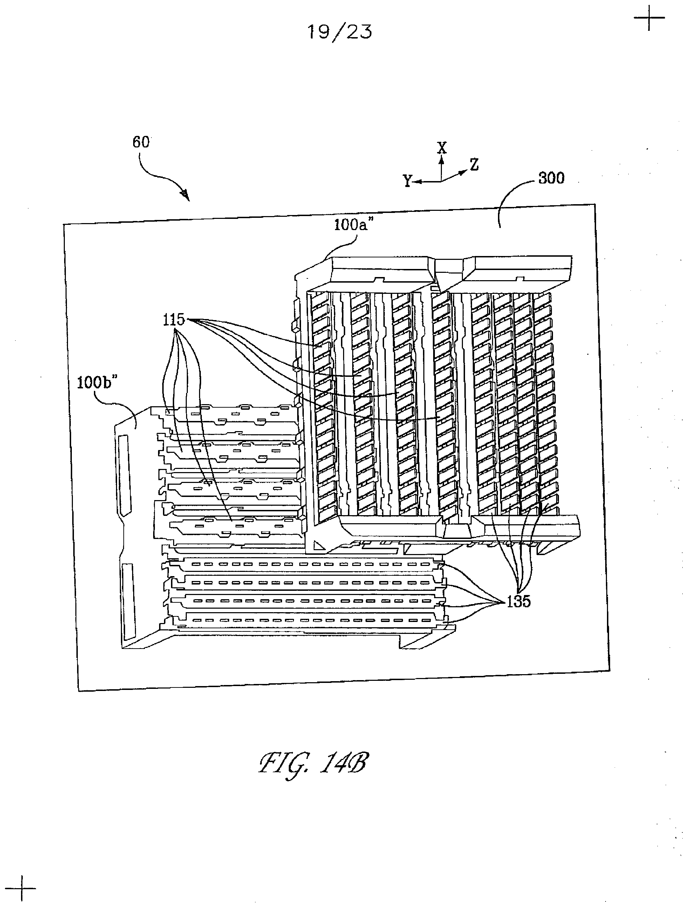

FIG. 14B depicts a perspective view of an electrical connector system 60 that includes of two 8x6 mixed connectors 100a", 100b" shown in FIG. 14A with orthogonal leadframe assemblies 115 mounted orthogonally to one another through the use of shared vias in a transparent midplane 300 and standard leadframe assemblies 115 terminated to the PCB or electrically connected by traces in the PCB.

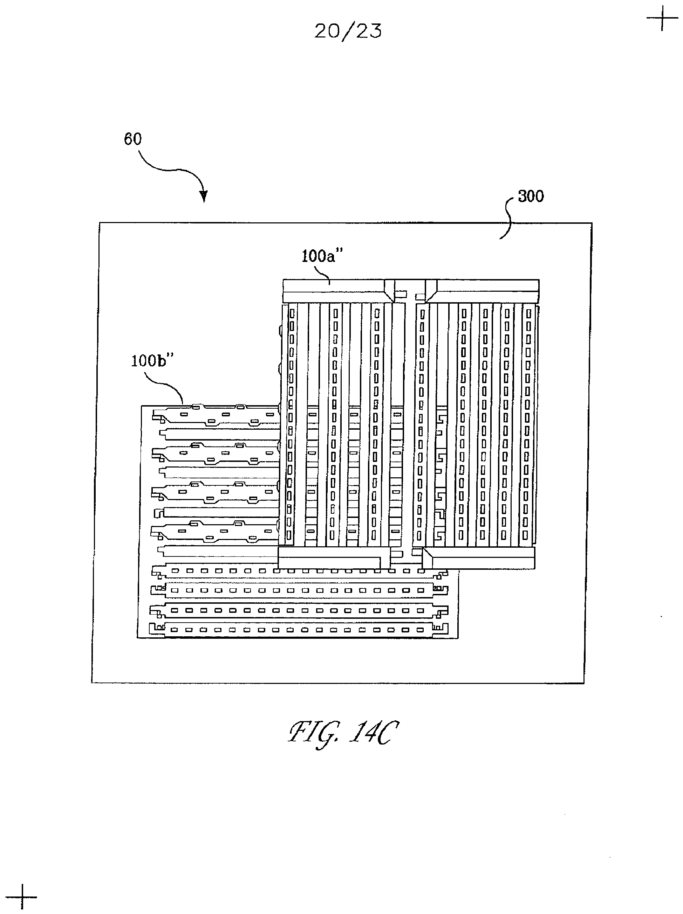

FIG. 14C depicts a front view of an electrical connector system 60 that includes of two 8x6 mixed connectors 100a", 100b" shown in FIGs. 14A and 14B.

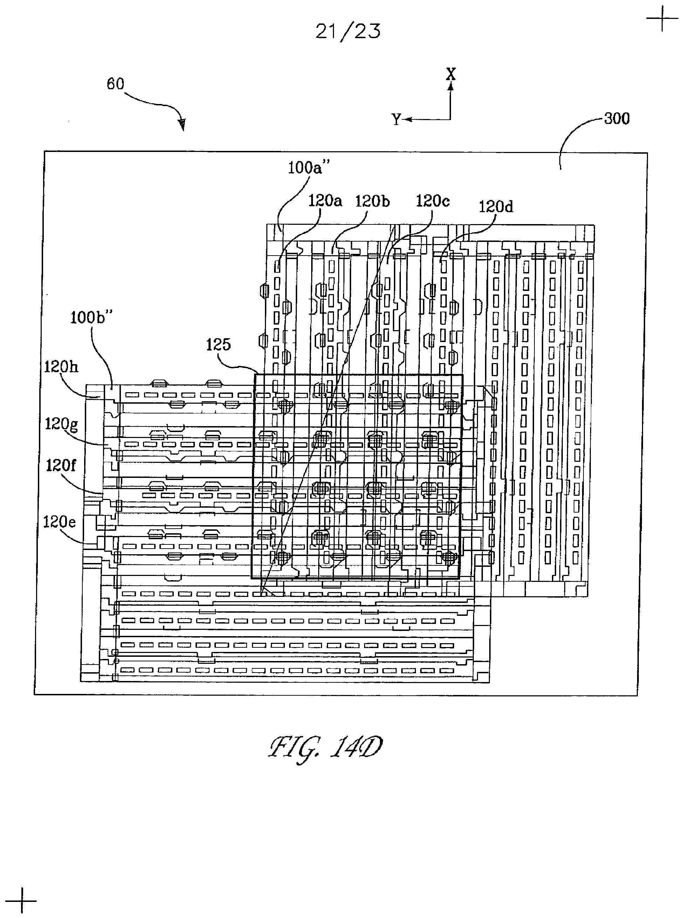

FIG. 14D shows the electrical connector system 60 shown in FIG. 14C. Connectors 100a" and 100b" each include sixteen orthogonal differential signal pairs (and the associated ground contacts) that overlap and are orthogonally connected through midplane 300, as illustrated by box 125. Connector 100a" includes orthogonal leadframe assemblies 120a-120d and connector 100b" includes standard leadframe assemblies 115.

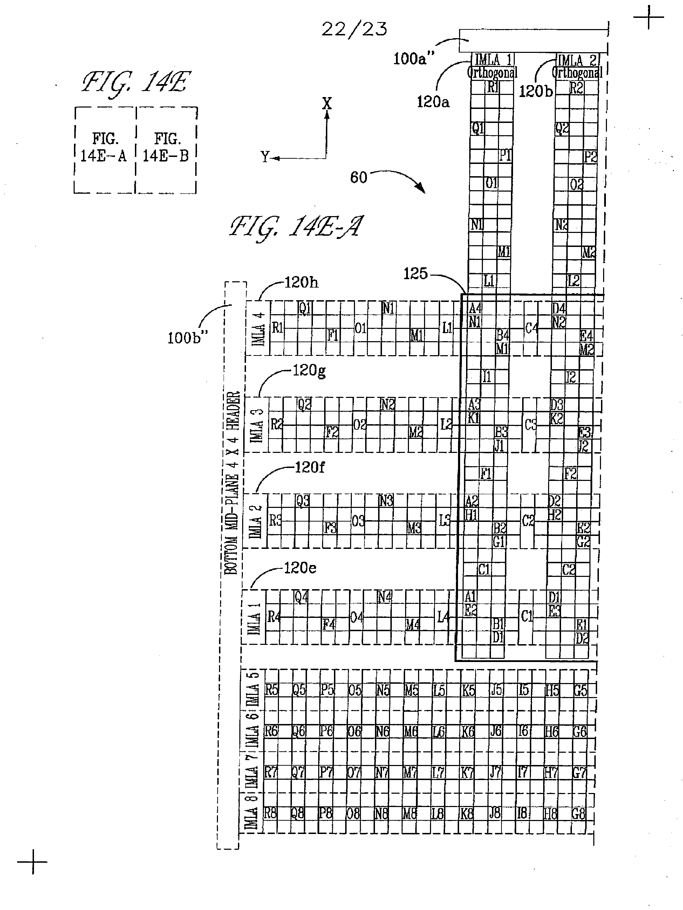

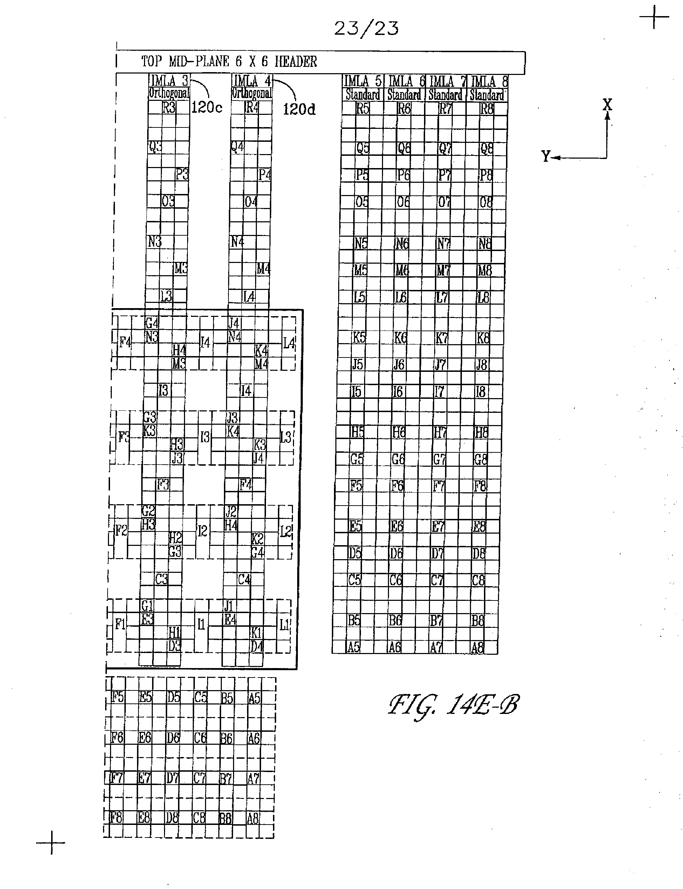

FIGs. 14E-A and 14E-B are created to be positioned side-by-side, as shown in FIG. 14E, with the dashed lines positioned coincident with each other. FIG. 14E does not fit on one page of paper so it has been separated for re-combination.

FIGs. 14, 14E-A, 14E-B depict a pin-out diagram of an electrical connector system 60. Bottom mid-plane 4x4 header 100b" includes contact row/columns 220a-220d with jogged contact tails N1, Ml; K1, J1 and top mid-plane 6x6 header 100a" includes row/columns 120a-120d with jogged contact tails A43 B4; A3, B3. FIGs. 14E-A, 14E-B which is shown from a transparent view of a midplane, shows the details of electrical common via mating between orthogonal contact tails A4, B4; A3, B3, etc. of the top mid-plane 6x6 header with respective orthogonal contact tails Nl, Ml ; Kl, Jl, etc. of the bottom mid-plane 4x4 header positioned on the opposite side of the PCB. FIG. 9 shows sixteen (16) mated pairs 125 of orthogonal differential signal contacts, such as through common vias. Ground tails C13 C2, etc. are the same for both connectors and are electrically connected, such as by common vias. Also shown in FIGs. 14E-A, 14E-B, standard columns/rows of contact A5, B5; A6, B6, etc. are also provided for non-orthogonal termination to a PCB.

## Claims

1. An assembly (10) comprising:
a first electrical connector (100) comprising a plurality of differential signal contact pairs (123, 143), a second connector (200) and a printed circuit board (300), the first and second connectors (100, 200) being situated on opposite sides (301, 302) of the printed circuit board (300), wherein the first and second connectors (100, 200) are interconnected by means of common vias (323) of the printed circuit board (300),
wherein a first one of the plurality of differential signal pairs (123) of the first connector (100) comprises first and second contact tails configured to be received in respective vias of the printed circuit board (300) and a second one of the plurality of differential signal pairs comprises third (141) and fourth contact tails (143) that are received in respective vias (341, 343) of the printed circuit board;
wherein the first electrical connector (100) comprises a housing (110) holding a plurality of leadframe assemblies (115, 135), each leadframe assembly comprising a respective centerline and contact tails distributed along the respective centerline;
wherein the plurality of leadframe assemblies comprises second type leadframe assemblies (135) having contact tails disposed in pairs along a respective centerline;
wherein the second one of the differential signal contact pairs is on a second type leadframe assembly,
**characterized in that** the plurality of leadframe assemblies comprises first type leadframe assemblies (115) having contact tails jogged on opposite sides of the respective centerline;
wherein the first one of the differential signal contact pairs are on a first type leadframe assembly, and disposed in the common vias.

2. The assembly according to claim 1, wherein the first and second contact tails (121, 123) are disposed on opposite sides of a first respective centerline and the third and fourth contact tails (141, 143) are disposed on a second respective common centerline that is adjacent and parallel to the first common respective centerline.

3. The assembly according to claim 2, further comprising a third differential signal pair arranged along a third respective centerline that is adjacent and parallel to the first respective centerline, wherein a centerline spacing (360) between the first respective centerline and the second respective centerline is different than the centerline spacing between the second respective centerline and the third respective centerline.

4. The assembly according to any one of preceding claims, wherein the second electrical connector (200) comprises a plurality of leadframe assemblies (215), each of the plurality of leadframe assemblies (215) comprising a plurality of differential signal contact pairs (223),
wherein signal contacts of a differential signal contact pair are jogged on opposite sides of a respective centerline of a leadframe assembly (215).

5. The assembly according to claim 4, wherein the respective centerlines of the plurality of leadframe assemblies (115, 135) of the first electrical connector (100) are parallel to a first direction, and the respective centerlines of the plurality of leadframe assemblies (215) of the second electrical connector (200) are parallel to a second direction different from the first direction.

6. The assembly according to claim 5, wherein the first and second directions are orthogonal to one another.

7. The assembly according to any one of claims -4 - 6, wherein the contact tails of the first one of the plurality of differential signal contact pairs (123) of the first connector (100) contact respective contact tails of a differential signal contact pair (223) of the second connector (200) through the common vias (323).

8. The assembly according to any one of preceding claims, wherein the first connector (100) comprises more leadframe assemblies than the second connector (200).

9. An electrical connector (100), **characterized in that** the electrical connector (100) comprises first type leadframe assemblies (115) and second type leadframe assemblies (135),
the first type leadframe assemblies (115) having contact tails (123) jogged on opposite sides of respective leadframe assembly centerlines; and
the second type leadframe assemblies (135) having contact tails (141, 143) disposed in pairs along respective leadframe assembly centerlines.

10. The electrical connector of claim 9, wherein the contact tails (123) of the first type leadframe assemblies (135) serve as signal contact tails, wherein the first type leadframe assemblies (135) further comprise a plurality of ground contact tails (121) disposed along respective leadframe assembly centerlines.

## Patentansprüche

1. Anordnung (10) mit:
einem ersten elektrischen Verbinder (100), der mehrere Differenzsignalkontaktpaare (123, 143) aufweist;
einem zweiten Verbinder (200); und
einer Leiterplatte (300),
wobei der erste und der zweite Verbinder (100, 200) auf gegenüberliegenden Seiten (301, 302) der Leiterplatte (300) angeordnet sind, wobei der erste und der zweite Verbinder (100, 200) mittels gemeinsamer Durchkontaktierungen (323) der Leiterplatte (300) miteinander verbunden sind,
wobei ein erstes der mehreren Differenzsignalkontaktpaare (123) des ersten Verbinders (100) erste und zweite Kontaktenden aufweist, die dafür konfiguriert sind, in jeweiligen Durchkontaktierungen der Leiterplatte (300) aufgenommen zu werden, und ein zweites der mehreren Differenzsignalkontaktpaare dritte (141) und vierte Kontaktenden (143) aufweist, die in entsprechenden Durchkontaktierungen (341, 343) der Leiterplatte aufgenommen werden,
wobei der erste elektrische Verbinder (100) ein Gehäuse (110) aufweist, das mehrere Leadframe-Anordnungen (115, 135) hält, wobei jede Leadframe-Anordnung eine jeweilige Mittellinie und Kontaktenden aufweist, die entlang der jeweiligen Mittellinie verteilt sind,
wobei die mehreren Leadframe-Anordnungen Leadframe-Anordnungen eines zweiten Typs (135) mit Kontaktenden aufweisen, die paarweise entlang einer jeweiligen Mittellinie angeordnet sind,
wobei das zweite der Differenzsignalkontaktpaare auf einer Leadframe-Anordnung des zweiten Typs angeordnet ist,
**dadurch gekennzeichnet, dass** die mehreren Leadframe-Anordnungen Leadframe-Anordnungen des ersten Typs (115) aufweisen, die Kontaktenden aufweisen, die auf gegenüberliegenden Seiten der jeweiligen Mittellinie angeordnet sind,
wobei das erste der Differenzsignalkontaktpaare auf einer Leadframe-Anordnung des ersten Typs und in den gemeinsamen Durchkontaktierungen angeordnet sind.

2. Anordnung nach Anspruch 1, wobei die ersten und zweiten Kontaktenden (121, 123) auf gegenüberliegenden Seiten einer ersten jeweiligen Mittellinie angeordnet sind und die dritten und vierten Kontaktenden (141, 143) auf einer zweiten jeweiligen gemeinsamen Mittellinie angeordnet sind, die sich benachbart und parallel zur ersten gemeinsamen jeweiligen Mittellinie erstreckt.

3. Anordnung nach Anspruch 2, ferner mit einem dritten Differenzsignalkontaktpaar, das entlang einer dritten jeweiligen Mittellinie angeordnet ist, die sich benachbart und parallel zur ersten jeweiligen Mittellinie erstreckt, wobei ein Mittellinienabstand (360) zwischen der ersten jeweiligen Mittellinie und der zweiten jeweiligen Mittellinie sich vom Mittellinienabstand zwischen der zweiten jeweiligen Mittellinie und der dritten jeweiligen Mittellinie unterscheidet.

4. Anordnung nach einem der vorhergehenden Ansprüche, wobei der zweite elektrische Verbinder (200) mehrere Leadframe-Anordnungen (215) aufweist, wobei jede der mehreren Leadframe-Anordnungen (215) mehrere Differenzsignalkontaktpaare (223) aufweist,
wobei Signalkontakte eines Differenzsignalkontaktpaars auf gegenüberliegenden Seiten einer jeweiligen Mittellinie einer Leadframe-Anordnung (215) angeordnet sind.

5. Anordnung nach Anspruch 4, wobei die jeweiligen Mittellinien der mehreren Leadframe-Anordnungen (115, 135) des ersten elektrischen Verbinders (100) sich parallel zu einer ersten Richtung erstrecken und die jeweiligen Mittellinien der mehreren Leadframe-Anordnungen (215) des zweiten elektrischen Verbinders (200) sich parallel zu einer zweiten Richtung erstrecken, die sich von der ersten Richtung unterscheidet.

6. Anordnung nach Anspruch 5, wobei die erste und die zweite Richtung sich orthogonal zueinander erstrecken.

7. Anordnung nach einem der Ansprüche 4 bis 6, wobei die Kontaktenden des ersten unter den mehreren Differenzsignalkontaktpaaren (123) des ersten Verbinders (100) mit jeweiligen Kontaktenden eines Differenzsignalkontaktpaars (223) des zweiten Verbinders (200) über die gemeinsamen Durchkontaktierungen (323) in Kontakt stehen.

8. Anordnung nach einem der vorhergehenden Ansprüche, wobei der erste Verbinder (100) mehr Leadframe-Anordnungen aufweist als der zweite Verbinder (200).

9. Elektrischer Verbinder (100), **dadurch gekennzeichnet, dass** der elektrische Verbinder (100) Leadframe-Anordnungen (115) eines ersten Typs und Leadframe-Anordnungen (135) eines zweiten Typs aufweist,
wobei die Leadframe-Anordnungen des ersten Typs (115) Kontaktenden (123) aufweisen, die auf gegenüberliegenden Seiten jeweiliger Mittellinien der Leadframe-Anordnungen angeordnet sind, und
die Leadframe-Anordnungen des zweiten Typs (135) Kontaktenden (141, 143) aufweisen, die paarweise entlang jeweiliger Mittellinien der Leadframe-Anordnungen angeordnet sind.

10. Elektrischer Verbinder nach Anspruch 9, wobei die Kontaktenden (123) der Leadframe-Anordnungen (135) des ersten Typs als Signalkontaktenden dienen, und wobei die Leadframe-Anordnungen (135) des ersten Typs ferner mehrere Massekontaktenden (121) aufweisen, die entlang jeweiliger Mittellinien der Leadframe-Anordnungen angeordnet sind.

## Revendications

1. Ensemble (10) comprenant :
un premier connecteur électrique (100) comprenant une pluralité de paires de contacts de signaux différentiels (123, 143), un second connecteur (200) et une carte de circuit imprimé (300), les premier et second connecteurs (100, 200) étant situés sur des côtés opposés (301, 302) de la carte de circuit imprimé (300), dans lequel les premier et second connecteurs (100, 200) sont interconnectés au moyen de trous d'interconnexion communs (323) de la carte de circuit imprimé (300),
dans lequel une première paire parmi la pluralité de paires de signaux différentiels (123) du premier connecteur (100) comprend des première et deuxièmes extrémités de contact configurées pour être reçues dans des trous d'interconnexion respectifs de la carte de circuit imprimé (300) et une deuxième paire parmi la pluralité de paires de signaux différentiels comprend des troisième (141) et quatrième extrémités de contact (143) qui sont reçues dans des trous d'interconnexion respectifs (341, 343) de la carte de circuit imprimé ;
dans lequel le premier connecteur électrique (100) comprend un boîtier (110) portant une pluralité d'ensembles de grille de connexion (115, 135), chaque ensemble de grille de connexion comprenant une ligne centrale respective et des extrémités de contact réparties le long de la ligne centrale respective ;
dans lequel la pluralité d'ensembles de grille de connexion comprend des ensembles de grille de connexion de second type (135) ayant des extrémités de contact disposées par paires le long d'une ligne centrale respective ;
dans lequel la deuxième paire parmi les paires de contacts de signaux différentiels est sur un ensemble de grille de connexion de second type,
**caractérisé en ce que** la pluralité d'ensembles de grille de connexion comprend des ensembles de grille de connexion de premier type (115) ayant des extrémités de contact courant sur des côtés opposés de la ligne centrale respective ;
dans lequel la première paire parmi les paires de contacts de signaux différentiels sont sur un ensemble de grille de connexion de premier type, et disposées dans les trous d'interconnexion communs.

2. Ensemble selon la revendication 1, dans lequel les première et deuxième extrémités de contact (121, 123) sont disposées sur des côtés opposés d'une première ligne centrale respective et les troisième et quatrième extrémités de contact (141, 143) sont disposées sur une deuxième ligne centrale commune respective qui est adjacente et parallèle à la première ligne centrale respective commune.

3. Ensemble selon la revendication 2, comprenant en outre une troisième paire de signaux différentiels agencée le long d'une troisième ligne centrale respective qui est adjacente et parallèle à la première ligne centrale respective, dans lequel un espacement de ligne centrale (360) entre la première ligne centrale respective et la deuxième ligne centrale respective est différent de l'espacement de ligne centrale entre la deuxième ligne centrale respective et la troisième ligne centrale respective.

4. Ensemble selon l'une quelconque des revendications précédentes, dans lequel le second connecteur électrique (200) comprend une pluralité d'ensembles de grille de connexion (215), chacun de la pluralité d'ensembles de grille de connexion (215) comprenant une pluralité de paires de contacts de signaux différentiels (223),
dans lequel des contacts de signaux d'une paire de contacts de signaux différentiels courent sur des côtés opposés d'une ligne centrale respective d'un ensemble de grille de connexion (215).

5. Ensemble selon la revendication 4, dans lequel les lignes centrales respectives de la pluralité d'ensembles de grille de connexion (115, 135) du premier connecteur électrique (100) sont parallèles à une première direction, et les lignes centrales respectives de la pluralité d'ensembles de grille de connexion (215) du second connecteur électrique (200) sont parallèles à une seconde direction différente de la première direction.

6. Ensemble selon la revendication 5, dans lequel les première et seconde directions sont orthogonales l'une à l'autre.

7. Ensemble selon l'une quelconque des revendications 4 à 6, dans lequel les extrémités de contact de la première paire parmi la pluralité de paires de contacts de signaux différentiels (123) du premier connecteur (100) sont en contact avec des extrémités de contact respectives d'une paire de contacts de signaux différentiels (223) du second connecteur (200) à travers les trous d'interconnexion communs (323).

8. Ensemble selon l'une quelconque des revendications précédentes, dans lequel le premier connecteur (100) comprend davantage d'ensembles de grille de connexion que le second connecteur (200).

9. Connecteur électrique (100), **caractérisé en ce que** le connecteur électrique (100) comprend des ensembles de grille de connexion de premier type (115) et des ensembles de grille de connexion de second type (135),
les ensembles de grille de connexion de premier type (115) ayant des extrémités de contact (123) courant sur des côtés opposés de lignes centrales d'ensemble de grille de connexion respectives ; et
les ensembles de grille de connexion de second type (135) ayant des extrémités de contact (141, 143) disposées par paires le long de lignes centrales d'ensemble de grille de connexion respectives.

10. Connecteur électrique selon la revendication 9, dans lequel les extrémités de contact (123) des ensembles de grille de connexion de premier type (135) servent d'extrémités de contact de signal, dans lequel les ensembles de grille de connexion de premier type (135) comprennent en outre une pluralité d'extrémités de contact de masse (121) disposées le long de lignes centrales d'ensemble de grille de connexion respectives.
